# EUROPÄISCHE PATENTSCHRIFT

(11) **EP 0 844 646 B1**
(45) Veröffentlichungstag und Bekanntmachung des Hinweises auf die Patenterteilung: **15.09.2004**
(21) Anmeldenummer: 97890228.6
(22) Anmeldetag: 14.11.1997
(51) Int. Cl.: H01L 21/00

(54) **Träger für scheibenförmige Gegenstände**
Holder for disc-like substrates
Support pour de substrats en forme de disque

(30) Priorität: 20.11.1996 AT 202496
(43) Veröffentlichungstag der Anmeldung: 27.05.1998
(73) Patentinhaber: SEZ AG, 9500 Villach (AT)
(72) Erfinder: Pirker, Willibald, 9530 Bad Bleiberg (Kärnten) (AT)
(74) Vertreter: Hehenberger, Reinhard, Dipl.-Ing.

(56) Entgegenhaltungen:
- US-A- 4 603 466
- US-A- 5 447 570
- US-A- 5 492 566
- PATENT ABSTRACTS OF JAPAN vol. 017, no. 484 (E-1426), 2.September 1993 -& JP 05 121530 A (TOKYO ELECTRON LTD), 18.Mai 1993,

## Beschreibung

Die Erfindung betrifft einen Träger für scheibenförmige Gegenstände, insbesondere für Siliziumscheiben, während des Behandelns derselben mit einer Behandlungsflüssigkeit mit den Merkmalen des einleitenden Teils von Anspruch 1.

Solche Träger ("chucks") sind in verschiedenen Ausführungsformen bekannt. Grundsätzlich gibt es zwei Ausführungsformen, nämlich Träger, die an der dem zu haltenden Gegenstand zugekehrten Fläche Zapfen tragen, welche den scheibenförmigen Gegenstand zur Seite hin festhalten (siehe US 4 903 717 A, US-5,492,566 A und US 5 513 668 A) und Träger, die den scheibenförmigen Gegenstand am Träger durch Anlegen von Unterdruck festhalten (siehe US 5 421 595 A).

Die bekannten Träger erlauben das Behandeln scheibenförmiger Gegenstände auf ihrer vom Träger abgekehrten Fläche, wobei die dem Träger zugekehrte Fläche nicht behandelt wird, da das Behandlungsmedium (z.B. die Ätzflüssigkeit) durch das aus der Ringdüse austretende und zwischen dem scheibenförmigen Gegenstand und der ihm zugekehrten Fläche des Trägers radial nach außen strömende Gas (vornehmlich Stickstoff) daran gehindert wird, auf die Unterseite des Trägers zu gelangen.

Aus der US 5 447 570 A ist ein Träger für ein Halbleitersubstrat bekannt, wobei der Träger das Halbleitersubstrat hält, während dieses nach dem CVD-Verfahren mit einer Beschichtung versehen wird, wobei verhindert werden soll, dass der Rand und die Rückseite des Halbleitersubstrates beschichtet wird. Bei der US 5 447 570 A wird keine Rückseitenspülung des Halbleitersubstrates ausgeführt. Bei diesem Träger sind (sh. beispielsweise Fig. 15) beidseitig einer außerhalb des Randes des Halbleitersubstrates angeordneten Stufe über den Umfang des Trägers verteilt Austrittsöffnungen vorgesehen, die über einen ringförmigen Kanal und einzelne Zuführbohrungen mit Spülgas beaufschlagt werden.

Häufig stellt sich jedoch die Aufgabe, auch den Randbereich des scheibenförmigen Gegenstandes, insbesondere eines Siliziumwafers, auf der dem Träger zugekehrten Fläche mit einer Behandlungsflüssigkeit zu behandeln. Dies ist mit den derzeit üblichen Konstruktionen von Trägern nicht ohne weiteres möglich.

Der Erfindung liegt die Aufgabe zugrunde, einen Träger zur Verfügung zu stellen, der es nicht nur erlaubt, die vom Träger abgekehrte Fläche des scheibenförmigen Gegenstandes, sondern auch den Außenrand und einen ringförmigen Randbereich der dem Träger zugekehrten Fläche des scheibenförmigen Gegenstandes mit einer Behandlungsflüssigkeit zu behandeln.

Erfindungsgemäß wird diese Aufgabe bei einem Träger der eingangs genannten Gattung im wesentlichen durch die Merkmale des kennzeichnenden Teils von Anspruch 1 gelöst.

Bevorzugte und vorteilhafte Ausführungsformen des erfindungsgemäßen Trägers sind Gegenstand der Unteransprüche.

Durch die in der dem scheibenförmigen Gegenstand zugekehrten Fläche vorgesehene, kreisförmige Stufe, die außerhalb der Ringdüse, aus der Stickstoffgas austritt, angeordnet ist und als Abreißkante wirkt, gelangt Behandlungsflüssigkeit, Ätzflüssigkeit oder Spülflüssigkeit um den Außenrand des scheibenförmigen Gegenstandes herum auf dessen dem Träger zugekehrte Fläche und behandelt, z.B. ätzt oder spült, den scheibenförmigen Gegenstand auf dieser Fläche in einem außerhalb der Stufe liegenden, im wesentlichen ringförmigen Bereich. Die Behandlungsflüssigkeit wird durch den Gasstrom, der aus der Ringdüse austritt und zwischen dem Gegenstand und dem Träger abströmt, in vorteilhafter Weise darin gehindert, weiter als erwünscht, zur Mitte des scheibenförmigen Gegenstandes hin zu wandern.

Weitere Einzelheiten, Merkmale und Vorteile des erfindungsgemäßen Trägers ergeben sich aus der nachstehenden Beschreibung der Erfindung, in der auf die Zeichnungen, in welchen ein erfindungsgemäßer Träger in Ausführungsbeispielen gezeigt ist, Bezug genommen wird.

Es zeigt:
Fig. 1 einen Träger mit an ihm gehaltenem Siliziumwafer;
Fig. 2 eine vergrößerte Einzelheit im Bereich der Stufe;
und Fig. 3 die Strömungsverhältnisse im Bereich der Stufe.

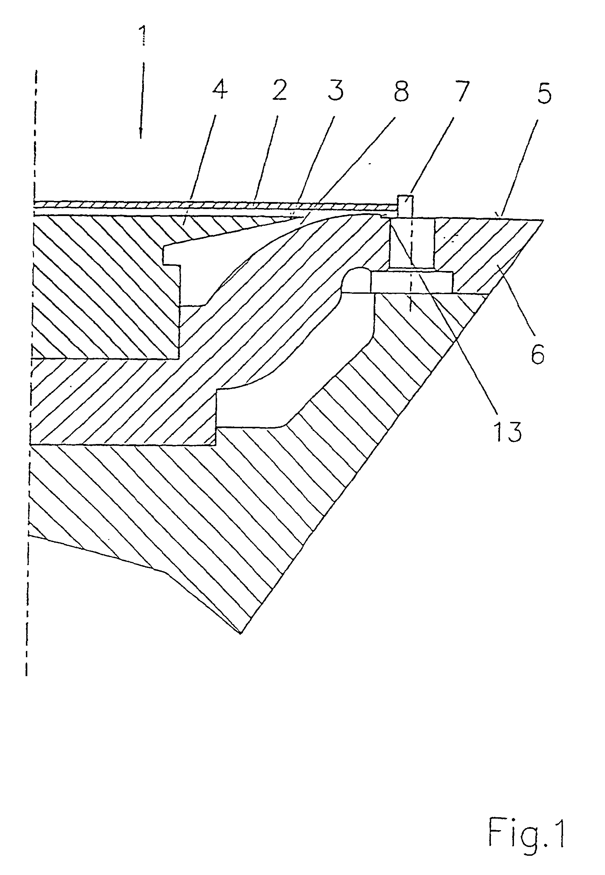

Ein in Fig. 1 gezeigter Träger 1 ist im Prinzip aus der US 4 903 717 A und der US 5 513 668 A bekannt. Bei diesem bekannten Träger 1 wird dessen dem scheibenförmigen Gegenstand 2 zugekehrte Fläche von einer Kreisfläche 3 eines inneren Teils 4 und einer Kreisringfläche 5 eines äußeren (ringförmigen) Teils 6 gebildet. Im äußeren Teil 6 sind mehrere radial verstellbare Zapfen 7 ("pins") angeordnet, durch die der Gegenstand 2 (z.B. ein Silizium-Wafer) seitlich abgestützt wird.

Zwischen dem inneren Teil 4 und dem äußeren Teil 6 des Trägers 1 ist eine ringförmige Düse 8 vorgesehen, die als Ringspalt zwischen den Teilen 4 und 6 ausgebildet ist. Die ringförmige Düse 8 wird mit Druckgas, vornehmlich Stickstoff, beaufschlagt, so daß der scheibenförmige Gegenstand 2 an dem Träger 1, nach dem Bernoulli-Prinzip festgehalten wird, wobei er im Gleichgewichtszustand gleichsam über den Flächen 3 und 5 "schwebt".

In der dem scheibenförmigen Gegenstand 2 zugekehrten Fläche 5 des äußeren Teils 6 des Trägers 1 ist knapp außerhalb der Düse 8 eine Stufe 10 vorgesehen. Diese Stufe 10 ergibt sich dadurch, daß der radial äußere Teil der Fläche 5 gegenüber dem radial inneren Teil der Fläche 5 nach unten abgesetzt ist.

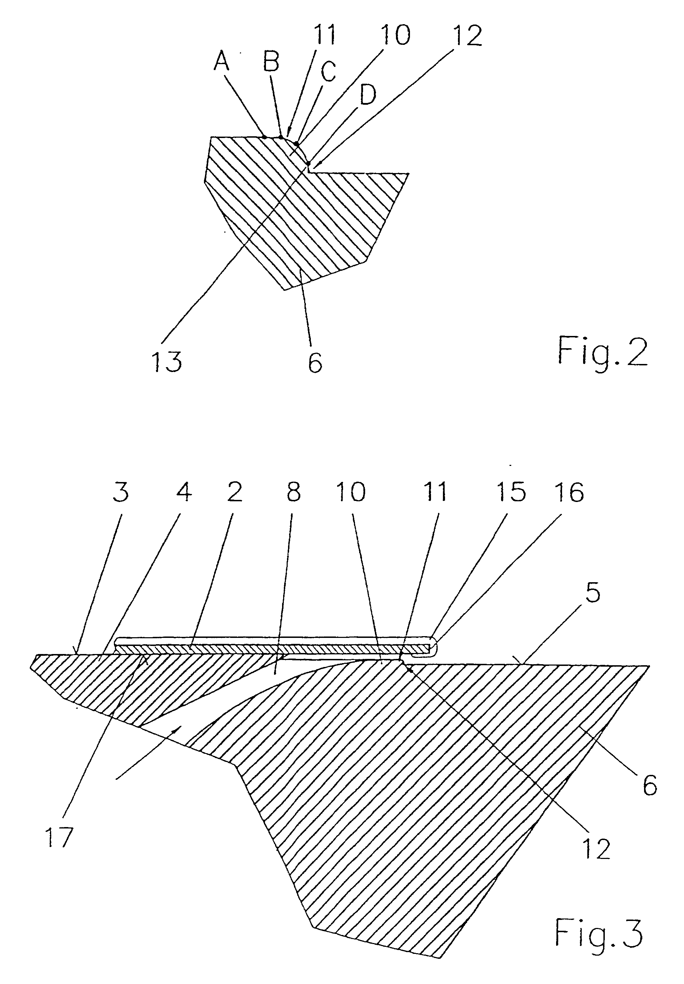

In Fig. 2 ist gezeigt, daß die Kante 11 der Stufe 10 abgerundet ist, wogegen der Übergang 12 zwischen der nach außen weisenden Fläche 13 der Stufe 10 und dem radial außerhalb der Stufe 10 liegende Teil der dem scheibenförmigen Gegenstand 2 zugekehrten Fläche 5 des äußeren Teils 6 scharfkantig, oder mit sehr kleinem Krümmungsradius ausgebildet sein kann.

Der Krümmungsradius der in Fig. 2 im Querschnitt gezeigten Stufe 10 nimmt in einer bevorzugten Ausführungsform der Erfindung radial nach außen nach und nach ab. So kann der Krümmungsradius im Bereich zwischen A und B, beispielsweise 3 mm, im Bereich zwischen B und C beispielsweise 0,8 mm und im Bereich zwischen C und D beispielsweise 0,2 mm betragen.

Durch die Stufe 10 ergeben sich die in Fig. 3 schematisch angedeuteten Strömungsverhältnisse der Behandlungsflüssigkeit 15. Auf die vom Träger 1 abgekehrte Fläche des scheibenförmigen Gegenstandes 2 aufgetragene Behandlungsflüssigkeit 15, z.B. eine Ätzflüssigkeit, wird nicht wie bei bekannten Trägern durch das aus der Ringdüse 8 austretende und zwischen dem scheibenförmigen Gegenstand 2 und dem Träger 1 herausströmende Gas vom Umfangsrand 16 des scheibenförmigen Gegenstandes 2 zur Gänze oder weit überwiegend weggeblasen, so daß es nicht auf dessen dem Träger 1 zugekehrte Fläche 17 gelangen kann. Vielmehr wandert die Behandlungsflüssigkeit 15 um den Umfangsrand 16 des scheibenförmigen Gegenstandes 2 herum auf dessen Fläche 17 bis annähernd in den Bereich der Stufe 10. So wird ein ringförmiger Bereich der dem Träger 1 zugekehrten Fläche 17 des scheibenförmigen Gegenstandes 2 von Behandlungsflüssigkeit 15 benetzt und behandelt. Der aus der Ringdüse 8 austretende Gasstrom verhindert, daß Behandlungsflüssigkeit 15 auf der Fläche 17 des Gegenstandes 2 weiter nach innen wandert, da die Strömung von Gas aus der Ringdüse 8 in einem radial innerhalb der Stufe 10 liegenden Bereich einem Nach-Innen-Kriechen von Behandlungsflüssigkeit 15 entgegenwirkt.

Die erfindungsgemäß vorgesehene Stufe 10 kann wie in Fig. 3 gezeigt, auch bei Trägern vorgesehen werden, bei welchen der scheibenförmige Gegenstand 2 nicht durch Zapfen seitlich festgehalten wird, sondern an beispielsweise ringförmigen Vorsprüngen des Trägers gehalten wird. Ein derartiger Träger ist beispielsweise aus der US 5 492 566 A bekannt.

Für den erfindungsgemäßen Träger 1 ist es weitestgehend belanglos, wie der scheibenförmige Gegenstand am Träger gehalten wird (Bernoulli-Prinzip/ Zapfen (Pins)/ angelegter Unterdruck), da für den erfindungsgemäß erzielten Effekt des Benetzens des Umfangsrandes 16 und eines ringförmigen Bereiches auf der dem Träger 1 zugekehrten Fläche 17 des scheibenförmigen Gegenstandes 2 mit Behandlungsflüssigkeit 15 allein die Stufe 10 und das aus der ringförmigen Düse 8 ausströmende Gas entscheidend ist.

Ein Ausführungsbeispiel der Erfindung kann zusammenfassend wie folgt beschrieben werden:

Bei einem Träger 1 für scheibenförmige Gegenstände 2, der in seiner dem scheibenförmigen Gegenstand 2 zugekehrten Fläche eine ringförmige Düse 8 für den Austritt von Druckgas aufweist, ist radial außerhalb der ringförmigen Düse 8 eine kreisförmige Stufe 10 vorgesehen. Behandlungsflüssigkeit 15, die auf die Oberseite eines Gegenstandes 2, der an einem mit der Stufe 10 versehenen Träger 1 gehalten ist, aufgebracht wird, wandert um den Umfangsrand 16 des Gegenstandes 2 herum auf die Unterseite 17 desselben und benetzt einen radial außerhalb der Stufe 10 liegenden Bereich der Unterseite 17 des Gegenstandes 2, bis es von dem aus der Ringdüse 8 austretenden Gas radial nach außen weggeblasen wird. So ergibt sich der Vorteil, daß Behandlungsflüssigkeit 15 nicht nur zum Umfangsrand 16 des Gegenstandes 2, sondern auch in einen ringförmigen Bereich der dem Träger 1 zugekehrten Unterseite 17 des scheibenförmigen Gegenstandes 2 gelangt und dort seine Wirkung entfalten kann.

## Patentansprüche

1. Träger (1) für einen scheibenförmigen Gegenstand (2), auf dem der scheibenförmige Gegenstand zu halten ist während er mit Behandlungsflüssigkeit behandelt wird, mit einer dem zu haltenden Gegenstand (2) zugekehrten Fläche (3, 5), in deren für die Aufnahme des Gegenstandes (2) bestimmten Bereich konzentrisch zur zentralen Achse des Trägers (1) eine ringförmige Düse (8) vorgesehen ist zur Einleitung eines Gasstroms zwischen dem Gegenstand und dem Träger, **dadurch gekennzeichnet, dass** in der dem scheibenförmigen Gegenstand (2) zugekehrten Fläche (3, 5) des Trägers (1), radial außerhalb der ringförmigen Düse (8) eine kreisförmige und konzentrisch zur ringförmigen Düse (8) und innerhalb dem für die Aufnahme des Gegenstandes (2) bestimmten Bereich der dem Gegenstand (2) zugekehrten Fläche (5), nach außen abfallende Stufe (10) angeordnet ist.

2. Träger nach Anspruch 1, **dadurch gekennzeichnet, dass** der Übergang (11) zwischen der dem scheibenförmigen Gegenstand zugekehrten Fläche (5) und der radial nach außen weisenden Stirnfläche (13) der Stufe (10) abgerundet ausgebildet ist.

3. Träger nach Anspruch 2, **dadurch gekennzeichnet, dass** der Krümmungsradius des abgerundeten Übergangs (11) mit zunehmendem Abstand zur Achse des Trägers zunehmend kleiner wird.

## Claims

1. Carrier (1) for a disc-shaped object (2), on which the disc-shaped object is to be held whilst it is treated with treatment fluid, having a face (3, 5), which is orientated towards the object (2) to be held, in the region of which face, intended for the accommodation of the object (2), an annular-nozzle (8) is provided, concentrically to the central axis of the carrier (1), for the introduction of a gas flow between the object and the carrier, **characterised in that** there is disposed in the face (3, 5) of the carrier (1), which face is orientated towards the disc-shaped object (2), radially outwith the annular nozzle (8), an outwardly inclined step (10) which is circular and concentric to the annular nozzle (8) and within the region, intended for the accommodation of the object (2), of the face (5) which is orientated towards the object (2).

2. Carrier according to claim 1, **characterised in that** the transition (11) between the face (5) which is orientated towards the disc-shaped object and the radially outwardly orientated end face (13) of the step (10) has a rounded configuration.

3. Carrier according to claim 2, **characterised in that** the radius of curvature of the rounded transition (11) becomes increasingly smaller with increasing spacing from the axis of the carrier.

## Revendications

1. Support (1) pour un substrat (2) en forme de disque, destine a maintenir celui-ci pendant qu'il subit l'action d'un liquide de traitement, ce support présentant une face (3, 5) en regard du substrat (2) à traiter et dans laquelle est prévue, dans une zone concentrique à l'axe du support (1) et définie pour accueillir le substrat (2), une buse annulaire (8) pour introduire un courant gazeux entre le substrat et le support, **caractérisé en ce que** dans la face (3, 5) du support située en regard du substrat (2) en forme de disque se trouve radialement à l'extérieur de la buse annulaire (8) un gradin (10) en pente descendante vers l'extériéur, de forme circulaire et concentrique à cette buse et situé à l'intérieur de la zone de la surface (5) située en face du substrat (2) et destinée à accueillir ce substrat.

2. Support (1) selon la revendication 1, **caractérisé en ce que** la zone de transition (11) située entre la face en regard du substrat en forme de disque et la face frontale (13) du gradin (10) regardant radialement vers l'extérieur, est arrondie.

3. Support (1) selon la revendication 2, **caractérisé en ce que** le rayon de courbure de la transition (11) arrondie, diminue quand sa distance par rapport à l'axe du support augmente.
